# EUROPÄISCHE PATENTSCHRIFT

(11) **EP 1 622 438 B1**
(45) Veröffentlichungstag und Bekanntmachung des Hinweises auf die Patenterteilung: **02.12.2009**
(21) Anmeldenummer: 05106353.5
(22) Anmeldetag: 12.07.2005
(51) Int. Cl.: H05K 5/00

(54) **Elektrisches Gerät, insbesondere Sensor für ein Kraftfahrzeug**
Electronic apparatus, particularly vehicle sensor
Appareil électrique, capteur pour un véhicule en particulier

(30) Priorität: 30.07.2004 DE 102004036993
(43) Veröffentlichungstag der Anmeldung: 01.02.2006
(73) Patentinhaber: Continental Automotive GmbH, 30165 Hannover (DE)
(72) Erfinder: Plankl, Christian, 93055, Burgweinting (DE); Probst, Heinrich, 93093, Donaustauf (DE); Schober, Herbert, 93057, Regensburg (DE)

(56) Entgegenhaltungen:
- WO-A-92/11745
- WO-A-99/54901
- WO-A-03/079741
- US-A- 4 015 070

## Beschreibung

Die Erfindung betrifft ein elektrisches Gerät, insbesondere einen Sensor für ein Kraftfahrzeug.

Zum Ansteuern und Auslösen eines Personenschutzsystems in einem Kraftfahrzeug, wie einem Airbag oder einem anderen Personenschutzsystem, werden zur Detektion eines Aufpralls auf Druck, Beschleunigung oder Verformung reagierende Sensoren verwendet. Für eine effektive Schutzwirkung des Personenschutzsystems ist eine möglichst geringe Zeitdauer zwischen der Detektion eines Aufpralls und dem Auslösen des Personenschutzsystems notwendig.

Faseroptische Sensoren, die in einem Stoßfänger des Kraftfahrzeugs oder einer Tür untergebracht sind und auf eine Verformung des jeweiligen Bauteils reagieren, sind in der Lage nach einem Aufprall nahezu verzögerungsfrei ein Signal an ein Steuergerät abzugeben, welches dann über die Auslösung des Personenschutzsystems entscheidet. Das Steuergerät eines faseroptischen Sensors ist üblicherweise in der Nähe des Karosseriebereichs angeordnet, der durch die Lichtwellenleiter auf eine Kollision hin überwacht werden soll. Dies sind häufig Stellen an oder in der Karosserie, die Umwelteinflüssen, wie Feuchtigkeit und Nässe, ausgesetzt sind. Der Übergang zwischen dem faseroptischen Sensor, d.h. den Lichtwellenleitern und dem Steuergerät muss daher zuverlässig gegenüber Umwelteinflüssen abgedichtet sein, um eine Beschädigung des Steuergeräts und damit gegebenenfalls eine Fehlfunktion zu verhindern.

Um die analogen Signale eines Lichtwellenleiters zuverlässig auswerten zu können, ist es weiterhin notwendig, dass der faseroptische Sensor möglichst starr an das Steuergerät angekoppelt ist.

WO 03/079741, US 4015070 und WO 92/11745 offenbaren bekannte Gehäuse.

Die Aufgabe der vorliegenden Erfindung besteht deshalb darin, ein elektrisches Gerät, insbesondere einen Sensor, für ein Kraftfahrzeug anzugeben, welcher die eingangs genannten Anforderungen auf einfache und kostengünstige Weise erfüllt.

Diese Aufgabe wird durch ein elektrisches Gerät mit den Merkmalen des Patentanspruches 1 gelöst. Vorteilhafte Ausgestaltungen ergeben sich aus den abhängigen Patentansprüchen.

Das erfindungsgemäße elektrische Gerät weist ein Gehäuse auf, das an einer Stirnseite mit einer Öffnung versehen ist. Die Öffnung ist mit einem deckelartigen Gebilde verschlossen, das auf seiner Außenseite als Steckverbinder ausgebildet ist und das auf seiner Innenseite ein Befestigungsmittel für zumindest eine, elektrische Funktionsteile tragende, Trägerplatte aufweist. Da das elektrische Gerät im wesentlichen lediglich aus zwei Bauteilen, nämlich dem Gehäuse und dem deckelartigen Gebilde besteht, ist eine einfache und kostengünstige Fertigung möglich. Das deckelartige Gebilde ermöglicht hierbei einerseits die Aufnahme zumindest einer Trägerplatte, welche die für eine Auswertung die von einem Sensor gelieferten Signale übernimmt. Andererseits können die in dem elektrischen Gerät bereits ausgewerteten Signale über den Steckverbinder an ein anderes elektrisches Gerät übertragen werden. Sämtliche zur Ausbildung der gewünschten elektrischen Funktionen notwendigen Bauteile können damit an oder in dem deckelartigen Gebilde angeordnet werden. Das deckelartige Gebilde kann deshalb vollständig vorkonfektioniert werden und als Unterbaugruppe zugeliefert werden.

Bevorzugt ist es hierbei, wenn das Befestigungsmittel einen flächig ausgebildeten Trägerabschnitt aufweist. Hierdurch kann die Trägerplatte nicht nur punktuell, sonder flächig an dem deckelartigen Gebilde befestigt werden. Diese Vorgehensweise erhöht die Zuverlässigkeit des elektrischen Geräts, da dieses in einem Kraftfahrzeug stark variierenden Umwelteinflüssen sowie mechanischen Belastungen, insbesondere Vibrationen ausgeliefert ist.

Gemäß einer bevorzugten Ausgestaltung der Erfindung ist der Steckverbinder zur Herstellung eines elektrischen und mechanischen Kontakts des Geräts mit einem Verbindungsmittel ausgebildet und weist von der Außenseite her zugängliche äußere Kontaktelemente auf, die elektrisch mit an oder in dem Befestigungsmittel vorgesehenen inneren Kontaktelementen elektrisch verbunden sind. Mit anderen Worten bedeutet dies, dass das deckelartige Gebilde Kontaktelemente auf seiner Außen- und Innenseite aufweist, die einen elektrischen Kontakt zueinander aufweisen. Dadurch können die in dem elektrischen Gerät gewonnenen Informationen über ein an den Steckverbinder anzuschließendes Kabel an ein weiteres Gerät übertragen werden.

Bevorzugt sind die inneren Kontaktelemente zumindest teilweise als Kontaktpins ausgebildet, welche neben einer elektrischen Kontaktierung der Trägerplatte eine mechanische Halterung derselben übernehmen. Die Herstellung einer elektrischen und mechanischen Kontaktierung einer Trägerplatte an dem deckelartigen Gebilde kann gemäß dieser Ausgestaltung somit ausschließlich über als Kontaktpins ausgebildete Kontaktelemente vorgenommen werden. Ein Verkleben oder Verschrauben der Trägerplatte an dem deckelartigen Gebilde ist darüber hinaus nicht notwendig, aber trotzdem denkbar. Eine schnelle und kostengünstige Fertigung ist hierdurch sichergestellt.

Zweckmäßigerweise sind die inneren Kontaktelemente in dem Trägerabschnitt des Befestigungsmittels ausgebildet. Dies ermöglicht eine besonders einfache und stabile Montage der Trägerplatte an dem deckelartigen Gebilde, da dieses im wesentlichen eine flächige Auflagefläche hat.

Gemäß einer bevorzugten Ausgestaltung der Erfindung ist das Befestigungsmittel zum Haltern von zwei Trägerplatten ausgebildet. Bevorzugt ist es hierbei, wenn die zwei Trägerplatten auf gegenüberliegenden Seiten des Trägerabschnitts angeordnet sind und über zumindest einige der inneren Kontaktelemente eine elektrische Verbindung zueinander, d.h. zwischen den zwei Trägerplatten, hergestellt ist. Das Vorsehen von zwei Trägerplatten im Inneren des elektrischen Geräts ermöglicht die Anordnung der elektrischen Funktionsteile auf den jeweiligen Trägerplatten nach rein funktionellen Gesichtspunkten. So könnte eine der Trägerplatten beispielsweise ausschließlich mit Elementen zum Empfangen der von dem Sensor gelieferten Signale ausgestattet sein. Die andere Trägerplatte könnte sämtliche zur Auswertung der von dem Sensor gelieferten Signale notwendigen Bauelemente aufweisen. Dies ist insbesondere dann von Vorteil, wenn Sensorbauteile und die zur Auswertung notwendigen Bauteile von unterschiedlichen Herstellern gefertigt und zugeliefert werden.

Es ist weiterhin bevorzugt, wenn zumindest eine der Trägerplatten von einem umlaufenden Rahmen des Trägerabschnitts des Befestigungsmittels umgeben ist. Hierdurch ist eine besonders stabile und starre Befestigung der Trägerplatte an dem deckelartigen Gebilde sichergestellt. Diese Ausgestaltung ermöglicht insbesondere die eingangs gestellte Anforderung einer möglichst starren Anbindung eines als Lichtwellenleiter ausgebildeten Sensors an das elektrische Gerät. Hierdurch ist sichergestellt, dass die von einem Lichtwellenleiter gelieferten Signale auch bei ungünstigen mechanischen Bedingungen nicht verfälscht durch das elektrische Geräte aufgenommen und gegebenenfalls zu einer Fehlinterpretation durch dieses führen werden.

Für einen besonderen Schutz der optischen und elektrischen Funktionsteile, welche auf der Trägerplatte montiert sind, ist der umlaufende Rahmen als wannenförmiger Trog ausgebildet, wobei die Trägerplatte in dem Trog angeordnet und der wannenförmige Trog des Trägerabschnitts mit der darin angeordneten Trägerplatte mit einer Vergussmasse ausgefüllt ist.

Neben einer verbesserten Verankerung der Trägerplatte an dem deckelartigen Gebilde ist dadurch zudem ein Feuchtigkeitsschutz für die auf der Trägerplatte montierten elektrischen Funktionsteile realisiert.

Um grundsätzlich das Eindringen von Feuchtigkeit oder Nässe in das Innere des elektrischen Geräts zu verhindern, weist das deckelartige Gebilde im Bereich der Öffnung des Gehäuses eine Verschlussplatte auf. Bevorzugt ist hierbei eine die Verschlussplatte umlaufende Dichtung vorgesehen, die zwischen der Stirnseite der Verschlussplatte und dem Gehäuse angeordnet ist.

Neben einem Schutz vor eindringender Feuchtigkeit in das Innere erlaubt es die Dichtung, die Verschlussplatte gemäß einer bevorzugten Ausgestaltung auf der Außenseite mit einer Vergussmasse zu umgeben. Hierdurch ist eine hermetische Versiegelung des Inneren des elektrischen Gerätes sichergestellt. Durch das Umgeben der Verschlussplatte mit einer Vergussmasse wird eine Abdichtung eines in das Innere des Gerätes geführten faseroptischen Sensors gewährleistet. Die Vergussmasse stellt eine weitere Fixierung des Sensors und eines eventuell erforderlichen Schutzschlauches dar, auch zur Begrenzung von Biegeradien. Darüber hinaus wird das deckelartige Gebilde dadurch in dem Gehäuse sicher mechanisch fixiert, wodurch keine Verschraubung erforderlich ist.

In einer besonderen Ausgestaltung ist die Verschlussplatte mehrteilig ausgebildet, wobei lediglich ein Verschlussplattenelement integraler Bestandteil des deckelartigen Gebildes ist und das oder die anderen Verschlussplattenelemente als separate Bauteile formschlüssig mit dem deckelartigen Gebilde verbindbar sind. Diese Variante ermöglicht die besonders einfache Anbindung eines faseroptischen Sensors an das elektrische Gerät, da dieser zwischen den beiden Verschlussplattenelementen hindurchgeführt werden kann. Hierdurch muss der faseroptische Sensor nicht durch eine Öffnung in der Verschlussplatte hindurch gezogen werden. Darüber hinaus ist eine schonende Fixierung des faseroptischen Sensors gewährleistet, insbesondere können Quetschungen des Sensors vermieden werden, die zu einer Verfälschung der Sensorsignale führen würden. Dabei kann durch eine mehrteilige Verschlussplatte eine Abdichtung von in das Gehäuseinnere geführten Bauteilen, wie dem faseroptischen Sensor, gewährleistet werden.

Weiter bevorzugt ist es dabei, wenn zwischen aneinander grenzende Stirnseitenabschnitte jeweiliger Verschlussplattenelemente eine Dichtung vorgesehen ist.

Weitere Vorteile und Merkmale der Erfindung werden nachfolgend anhand der Zeichnung näher erläutert. Es zeigen:
- Fig. 1: ein erfindungsgemäßes elektrisches Gerät im Querschnitt,
- Fig. 2: eine Explosionszeichnung, aus der die verschiedenen Bauteile eines erfindungsgemäßen elektrischen Geräts vor dem Zusammenbau hervorgehen,
- Fig. 3: eine Explosionszeichnung, aus der die verschiedenen Bauteile eines erfindungsgemäßen elektrischen Geräts vor dem Zusammenbau aus einer anderen Ansicht hervorgehen, und
- Fig. 4: ein erfindungsgemäßes elektrisches Gerät nach dem Zusammenbau in einer perspektivischen Darstellung.

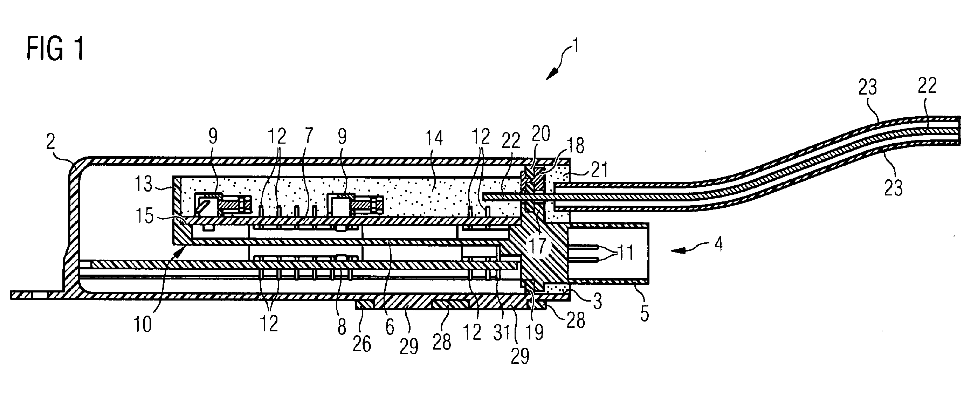

Figur 1 zeigt in einer Querschnittsdarstellung ein erfindungsgemäßes elektrisches Gerät 1. Das elektrische Gerät 1 stellt eine Steuer- und/oder Auswerteeinheit eines faseroptischen Sensors dar. Es weist ein, beispielsweise aus Aluminium bestehendes, Gehäuse 2 auf, welches an einer Stirnseite mit einer Öffnung 3versehen ist. Das Gehäuse 2 wird auch als Bechergehäuse bezeichnet. In das Gehäuse 2 ist ein deckelartiges Gebilde 4 eingeführt, welches sämtliche für die Funktion des elektrischen Gerätes notwendigen Bauelemente beinhaltet, eine elektrische Kontaktierung der Bauelemente von außen ermöglicht und darüber hinaus die Fixierung eines von außen ins Innere des Gehäuses verlaufenden faseroptischen Sensors übernimmt.

Hierzu weist das deckelartige Gebilde 4 auf seiner Außenseite einen Steckverbinder 5 auf, in dem äußere Kontaktelemente 11 ausgebildet sind. Im Gehäuseinneren weist das deckelartige Gebilde 4 einen Trägerabschnitt 10 auf, der zum Haltern zweier Trägerplatten 7, 8 ausgebildet ist. Die Trägerplatte 7 ist in einen wannenförmigen Trog 13 des Trägerabschnitts 10 eingesetzt. Als mechanische Auflagefläche dienen Auflagen 15, die längs der Wände des Trogs 13 ausgebildet sind. Die elektrische - und auch mechanische - Fixierung der Trägerplatte 7 an dem Trägerabschnitt 10 wird zudem durch innere Kontaktelemente 12 realisiert, welche in Form von Kontaktpins ausgebildet sind. Die inneren Kontaktelemente 12 sind auch auf der anderen Seite des Trägerabschnitts 10 ausgebildet und haltern dort die Trägerplatte 8. Die Fixierung der Trägerplatte 8 wird zusätzlich zu den inneren Kontaktelementen 12 durch einen oder mehrere Vorsprünge 31, die ebenfalls in Form eines Pins ausgebildet sind, hergestellt. Je nach Bedarf kann eine Vielzahl solcher Vorsprünge 31 entlang des Trägerabschnitts 10 vorgesehen werden. Die inneren Kontaktelemente 12 können dabei eine elektrische Verbindung zwischen elektrischen Funktionsteilen auf der Trägerplatte 7 und der Trägerplatte 8 herstellen. Sie dienen jedoch auch dazu, eine elektrische Verbindung zu den äußeren Kontaktelementen 11 in dem Steckverbinder 5 herzustellen.

Auf der Trägerplatte 7 sind beispielhaft zwei Diodenarrays 9 aufgebracht. Dies stehen mit einem faseroptischen Sensor, genauer einem Lichtwellenleiter 22 in Verbindung, der durch das deckelartige Gebilde 4 hindurchgeführt ist. Die genaue Anbindung des Lichtwellenleiters 22 an die Diodenarrays 9 mittels einer fiberoptischen Verbindung ist in der Figur nicht dargestellt, einem Fachmann jedoch ohne weiteres geläufig. Um die Übertragung von analogen Signalen des Lichtwellenleiters zu dem Diodenarray möglichst unverfälscht gewährleisten zu können, ist eine Vergussmasse 14 vorgesehen, welche in den wannenförmigen Trog 13 eingebracht ist und die Trägerplatte 7 sowie die darauf befindlichen elektrischen Funktionsteile vollständig abdeckt.

Das deckelartige Gebilde 4 weist weiterhin eine Verschlussplatte 16 auf, die zweigeteilt ist und zwei Verschlussplattenelemente 17, 18 beinhaltet. Das Verschlussplattenelement 17 ist dabei integral mit dem deckelartigen Gebilde 4 ausgebildet. Die Stirnseite des Verschlussplattenelements 17 ist von einer Dichtung 19 umgehen. Zwischen dem Verschlussplattenelement 17 und einem separaten Verschlussplattenelement 18 ist der Lichtwellenleiter 22 hindurchgeführt. Auch das Verschlussplattenelement 18 wird von einer Dichtung 20 umlaufen. Die Dichtungen 19, 20 dienen einerseits dazu, das Eindringen von Feuchtigkeit in das Gehäuseinnere zu unterbinden. Andererseits verhindern diese beim Aufbringen einer Vergussmasse 21 auf die Außenseite der Verschlussplatte 16 ein Eindringen derselben in das Gehäuseinnere. Die Vergussmasse 21 sorgt für eine zuverlässige Abdichtung des Lichtwellenleiters 22, der von einem Schutzschlauch 23 umgeben ist, gegenüber Umwelteinflüssen. Darüber hinaus werden der Lichtwellenleiter 22 und der von Vergussmasse umgebene Schutzschlauch 23 zusätzlich an dem elektrischen Gerät fixiert, so dass die gewünschte starre Verbindung zu den elektrischen Funktionselementen, d.h. im Ausführungsbeispiel den Diodenarrays, sichergestellt ist.

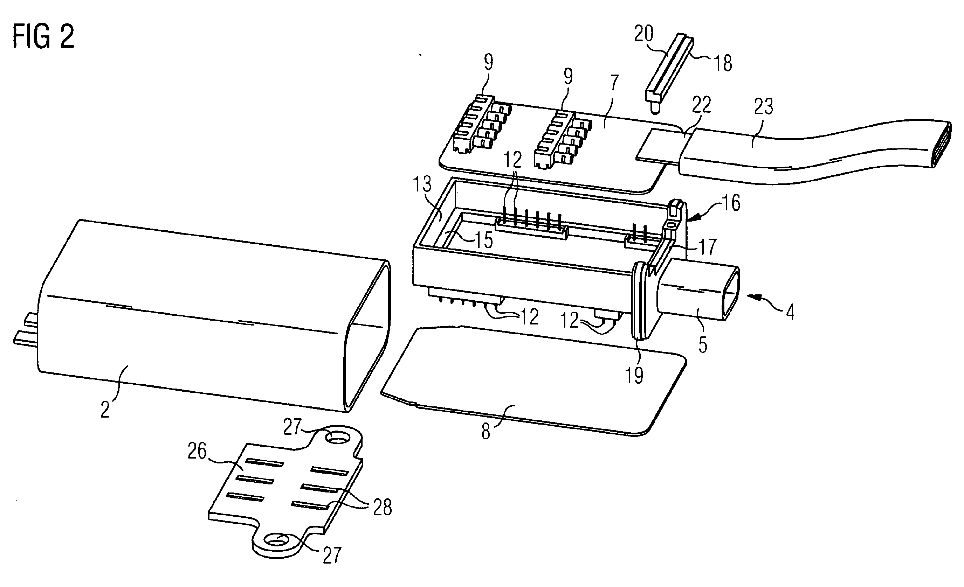

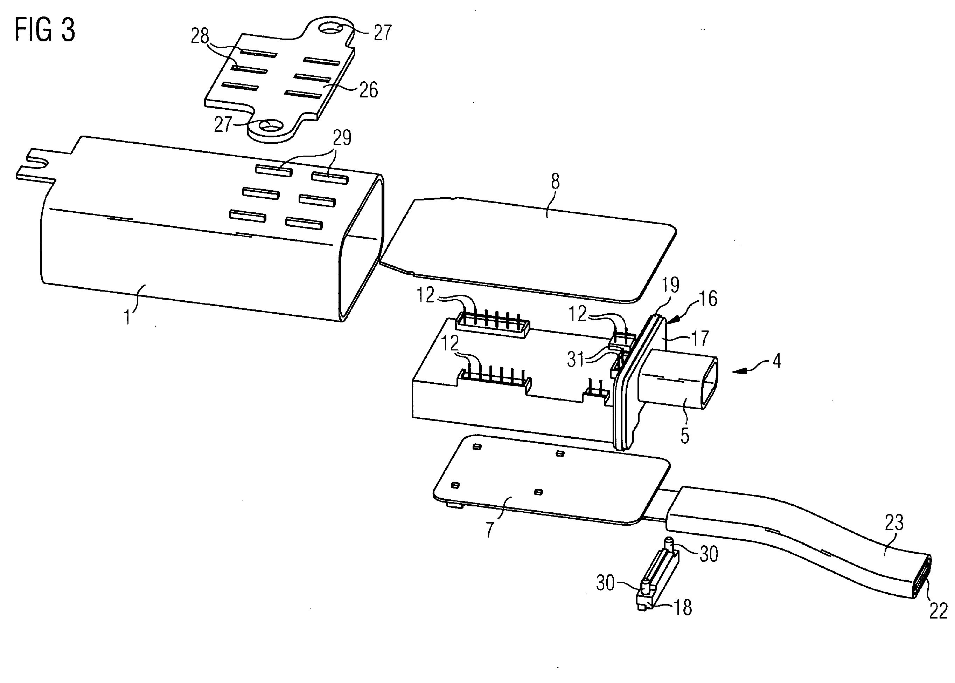

Aus den Figuren 2 und 3, die jeweils Explosionsdarstellungen der in dem elektrischen Gerät vor dem Zusammenbau darstellen, zeigen in übersichtlicher Weise die Gestaltung des deckelartigen Gebildes 4 und insbesondere den Aufbau der Verschlussplatte 16 in verbesserter Weise.

Das Verschlussplattenelement 17 ist dabei einerseits an die Gestalt des Lichtwellenleiters 22 angepasst, so dass dieser nach dem Zusammenfügen mit dem anderen Verschlussplattenelement 18 keiner Quetschung unterzogen wird. Als zusätzlicher Schutz gegen Quetschung des Lichtwellenleiters dienen die Dichtungen 19, 20. Die mechanische Befestigung des Verschlussplattenelements 18 an dem deckelartigen Gebilde 4 bzw. dem Verschlussplattenelement 17 erfolgt durch zwei Vorsprünge 30, die in entsprechende Aufnahmen in dem Verschlussplattenelement 17 eingefügt werden.

Weiterhin erkennbar ist eine Befestigungsplatte 26, die mit regelmäßig angeordneten Schlitzen 28 sowie seitlich zwei Durchbrüchen 27 versehen ist. Das Gehäuse 2 weist entsprechend ausgestaltete Vorsprünge 29 auf, die in die Schlitze 28 eingepresst werden können. Mittels der Durchbrüche 27 lässt sich das elektrische Gerät an einer Montagefläche, z.B. mittels Schrauben, fixieren.

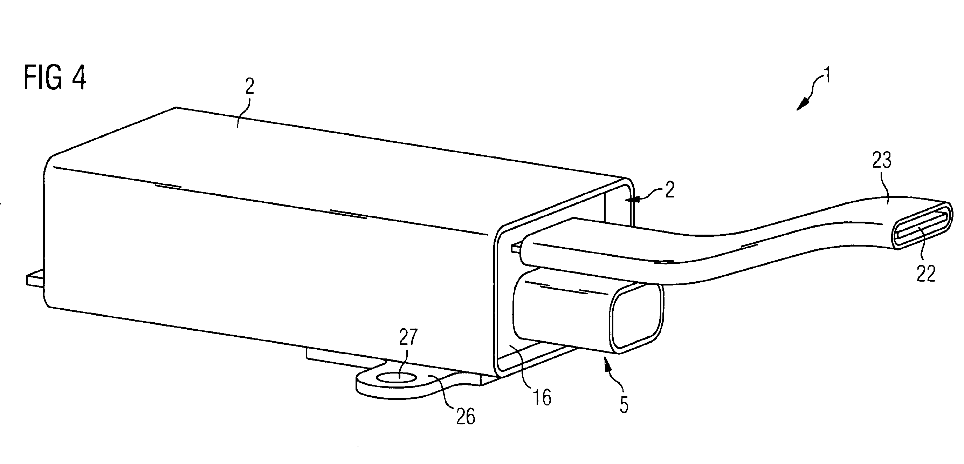

In Fig. 4 ist schließlich in perspektivischer Darstellung das erfindungsgemäße elektrische Gerät nach dem Zusammenbau sämtlicher Bauteile dargestellt. Dabei ist insbesondere der von einem Schutzschlauch 23 umgebene Lichtwellenleiter 22 besonders gut zu erkennen.

Die besonderen Vorteile des erfindungsgemäßen elektrischen Geräts bestehen darin, dass das deckelartige Gebilde sämtliche elektronischen Komponente beinhaltet, die ohne weiteres in verschiedenen Teilschritten vorkonfektioniert werden können. Zum Herstellen des elektrischen Gerätes ist lediglich das Zusammenführen eines fertig bestückten deckelartigen Gebildes mit dem Gehäuse notwendig. Das abschließende Vergießen der Außenseite der Verschlussplatte des deckelartigen Gebildes ermöglicht dabei eine zusätzliche Erhöhung der funktionellen Sicherheit. Die zweigeteilte Verschlussplatte und die diese jeweils umgebenden Dichtungen lassen sich in einem Zweikomponenten-Spritzgussverfahren herstellen. Alternativ könnten die Dichtungen auch im nachhinein um die jeweiligen Stirnflächen herum angebracht werden. Die Zweiteilung der Verschlussplatte ermöglicht eine schonende Fixierung des Lichtwellenleiters, wobei insbesondere kein Durchziehen des Lichtwellenleiters durch eine Öffnung in der Verschlussplatte notwendig ist. Durch die in den Verschlussplattenelementen vorgesehenen Dichtungen ist darüber hinaus eine zuverlässige Abdichtung für den nachfolgenden Vergussprozess gegeben.

Sämtliche für den Empfang der von dem Lichtwellenleiter gelieferten Signale notwendigen Bauelemente sind im Gehäuseinneren von einer Vergussmasse umgeben, wodurch eine sehr gute Fixierung der Lichtwellenleiteranschlüsse gewährleistet ist. Hierdurch ist das elektrische Gerät bezüglich Vibrationen unempfindlich, was in Anbetracht einer möglichen Einbaulage im Motorraum eines Kraftfahrzeugs vorteilhaft ist. Der Verguss der die optischen Komponente tragenden Leiterplatte sorgt weiterhin dafür, dass keine Einkopplung von Licht aus benachbarten Lichtwellenleitern oder anderen Lichtquellen möglich ist. Weiterhin erfolgt eine zuverlässige Fixierung und Zugentlastung des Lichtwellenleiters sowie des diesen umgebenden Schutzschlauchs.

## Patentansprüche

1. Elektrisches Gerät (1), insbesondere Sensor für ein Kraftfahrzeug, mit einem an einer Stirnseite mit einer Öffnung (3) versehenen Gehäuse (2), wobei die Öffnung mit einem deckelartigen Gebilde (4) verschlossen ist, das auf seiner Außenseite (24) als Steckverbinder (5) ausgebildet ist und das auf seiner Innenseite (25) ein Befestigungsmittel für zumindest eine, elektrische Funktionsteile (9) tragende, Trägerplatte (7,8) aufweist, wobei
a) das deckelartige Gebilde (4) im Bereich der Öffnung des Gehäuses (2) eine Verschlussplatte (16) aufweist, **dadurch gekennzeichnet, dass**
b) eine die Verschlussplatte (16) umlaufende Dichtung (19) vorgesehen ist, die zwischen der Stirnseite der Verschlussplatte (16) und dem Gehäuse (2) angeordnet ist und
c) die Verschlussplatte (16) mehrteilig ausgebildet ist, wobei lediglich ein Verschlussplattenelement (17) integraler Bestandteil des deckelartigen Gebildes (4) ist, und das oder die anderen Verschlussplattenelemente (18) als separate Bauteile formschlüssig mit dem deckelartigen Gebilde (4) verbindbar sind und
d) eine der Leiterplatten (7,8) mit einer lichtleitenden Faser (22) verbunden ist, und ein Abschnitt der lichtleitenden Faser (22) zwischen zwei Verschlussplattenelementen (17,18) von außen in das Innere des Gehäuses (2) geführt ist.

2. Gerät nach Anspruch 1,
**dadurch gekennzeichnet, dass**
das Befestigungsmittel einen flächig ausgebildeten Trägerabschnitt (10) aufweist.

3. Gerät nach Anspruch 1 oder 2,
**dadurch gekennzeichnet, dass**
der Steckverbinder (5) zur Herstellung eines elektrischen und mechanischen Kontakts des Geräts (1) mit einem Verbindungsmittel ausgebildet ist, und von der Außenseite her zugängliche äußere Kontaktelemente (11) aufweist, die elektrisch mit an oder in dem Befestigungsmittel vorgesehenen inneren Kontaktelementen (12) elektrisch verbunden sind.

4. Gerät nach Anspruch 3,
**dadurch gekennzeichnet, dass**
die inneren Kontaktelemente (12) zumindest teilweise als Kontaktpins ausgebildet sind, welche neben einer elektrischen Kontaktierung der Trägerplatte (7,8) eine mechanische Halterung derselben übernehmen.

5. Gerät nach einem der Ansprüche 3 oder 4,
**dadurch gekennzeichnet, dass**
die inneren Kontaktelemente (12) in dem Trägerabschnitt (10) des Befestigungsmittels ausgebildet sind.

6. Gerät nach einem der vorhergehenden Ansprüche,
**dadurch gekennzeichnet, dass**
das Befestigungsmittel zum Haltern von zwei Trägerplatten (7,8) ausgebildet ist.

7. Gerät nach Anspruch 6,
**dadurch gekennzeichnet, dass**
die zwei Trägerplatten (7,8) auf gegenüberliegenden Seiten des Trägerabschnitts (10) angeordnet sind und über zumindest einige der inneren Kontaktelemente (12) eine elektrische Verbindung zueinander hergestellt ist.

8. Gerät nach einem der vorhergehenden Ansprüche,
**dadurch gekennzeichnet, dass**
zumindest eine der Trägerplatten (7,8) von einem umlaufenden Rahmen des Trägerabschnitts (10) des Befestigungsmittels umgeben ist.

9. Gerät nach Anspruch 8,
**dadurch gekennzeichnet, dass**
der umlaufende Rahmen als wannenförmiger Trog ausgebildet ist, in dem die Trägerplatte (7,8) angeordnet ist, und der wannenförmige Trog (13) des Trägerabschnitts (10) mit der darin angeordneten Trägerplatte (7,8) mit einer Vergussmasse (14) ausgefüllt ist.

10. Gerät nach einem der vorangehenden Ansprüche,
**dadurch gekennzeichnet, dass**
zwischen aneinander grenzenden Stirnseitenabschnitten jeweiliger Verschlussplattenelemente (17,18) eine Dichtung (20) vorgesehen ist.

11. Gerät nach einem der vorangehenden Ansprüche,
**dadurch gekennzeichnet, dass**
die Verschlussplatte (16) auf der Außenseite mit einer Vergussmasse (21) umgeben ist.

## Claims

1. Electrical device (1), in particular a sensor for a motor vehicle, with a housing (2) provided with an opening (3) on an end face, the opening being closed with a cover-type formation (4), which is configured on its outside (24) as a plug-in connector (5), and which has on its inside (25) a securing means for at least one support plate (7, 8) bearing functioning electrical parts (9), wherein
a) the cover-type formation (4) has a closing plate (16) in the region of the opening of the housing (2),
**characterised in that**
b) a seal (19) running round the closing plate (16) is provided, being disposed between the end face of the closing plate (16) and the housing (2) and
c) the closing plate (16) is configured in multiple parts, with only one closing plate element (17) being an integral component of the cover-type formation (4) and it being possible to connect the or the other closing plate elements (18) as separate components in a form-fit manner to the cover-type formation (4) and
d) one of the printed circuit boards (7, 8) is connected to an optical fibre (22) and a segment of the optical fibre (22) is passed between two closing plate elements (17, 18) from outside into the interior of the housing (2).

2. Device according to claim 1,
**characterised in that** the securing means has a support segment (10) configured with a flat surface.

3. Device according to claim 1 or 2,
**characterised in that** the plug-in connector (5) is configured to establish an electrical and mechanical contact between the device (1) and a connecting means and has external contact elements (11) that are accessible from the outside, which are connected electrically to internal contact elements (12) provided on or in the securing means.

4. Device according to claim 3,
**characterised in that** the internal contact elements (12) are configured at least partially as contact pins, which as well as electrical contacting of the support plate (7, 8) ensure mechanical holding of the same.

5. Device according to one of claims 3 or 4,
**characterised in that** the internal contact elements (12) are configured in the support segment (10) of the securing means.

6. Device according to one of the preceding claims,
**characterised in that** the securing means is configured to hold two support plates (7, 8).

7. Method according to claim 6,
**characterised in that** the two support plates (7, 8) are disposed on opposing sides of the support segment (10) and an electrical connection to one another is established by way of at least some of the internal contact elements (12).

8. Device according to one of the preceding claims,
**characterised in that** at least one of the support plates (7, 8) is enclosed by a peripheral frame of the support segment (10) of the securing means.

9. Device according to claim 8,
**characterised in that** the peripheral frame is configured as a bowl-shaped trough, in which the support plate (7, 8) is disposed, and the bowl-shaped trough (13) of the support segment (10) with the support plate (7, 8) disposed therein is filled with a casting compound (14).

10. Device according to one of the preceding claims,
**characterised in that** a seal (20) is provided between adjacent end face segments of respective closing plate elements (17, 18).

11. Device according to one of the preceding claims,
**characterised in that** the closing plate (16) is surrounded by a casting compound (21) on the outside.

## Revendications

1. Appareil électrique (1), en particulier capteur pour un véhicule automobile, comprenant un boîtier (2) doté sur une face frontale d'une ouverture (3), dans lequel l'ouverture est fermée par une structure (4) de type couvercle, qui est conformée sur sa face externe (24) en connecteur enfichable (5) et qui présente sur sa face interne (25) un moyen de fixation pour au moins une plaque de support (7, 8) portant des parties électriques fonctionnelles (9), dans lequel
a) la structure (4) de type couvercle présente une plaque de fermeture (16) dans la zone de l'ouverture du boîtier (2),
**caractérisé en ce que**
b) il est prévu un joint d'étanchéité (19) entourant la plaque de fermeture (16), lequel joint d'étanchéité est aménagé entre la face frontale de la plaque de fermeture (16) et le boîtier (2), et
c) la plaque de fermeture (16) est formée de plusieurs parties, seul un élément de la plaque de fermeture (17) faisant partie intégrante de la structure (4) de type couvercle et le ou les autres éléments (18) de la plaque de fermeture pouvant être raccordés, comme composants séparés, par adaptation de forme, à la structure (4) de type couvercle, et
d) une des plaques conductrices (7, 8) est connectée à une fibre photoconductrice (22) et une section de la fibre photoconductrice (22) est guidée entre deux éléments de la plaque de fermeture (17, 18) de l'extérieur à l'intérieur du boîtier (2).

2. Appareil selon la revendication 1,
**caractérisé en ce que** le moyen de fixation présente une section de support (10) se présentant à plat.

3. Appareil selon la revendication 1 ou 2,
**caractérisé en ce que** le connecteur enfichable (5) est conformé de manière à établir un contact électrique et mécanique de l'appareil (1) avec un moyen de connexion et présente des éléments de contact externes (11) accessibles depuis la face externe, qui sont connectés électriquement à des éléments de contact internes (12) prévus sur ou dans le moyen de fixation.

4. Appareil selon la revendication 3,
**caractérisé en ce que** les éléments de contact internes (12) se présentent au moins en partie sous la forme de broches de contact, qui assurent, outre une mise en contact électrique de la plaque de support (7, 8), un soutien mécanique de cette dernière.

5. Appareil selon l'une quelconque des revendications 3 ou 4, **caractérisé en ce que**
les éléments de contact internes (12) sont formés dans la section de support (10) du moyen de fixation.

6. Appareil selon l'une quelconque des revendications précédentes, **caractérisé en ce que**
le moyen de fixation est conformé pour soutenir deux plaques de support (7, 8).

7. Appareil selon la revendication 6,
**caractérisé en ce que** les deux plaques de support (7, 8) sont aménagées sur des faces opposées de la section de support (10) et une connexion électrique mutuelle est établie via au moins certains des éléments de contact internes (12).

8. Appareil selon l'une quelconque des revendications précédentes, **caractérisé en ce qu'**au moins une des plaques de support (7, 8) est entourée par un cadre périphérique de la section de support (10) du moyen de fixation.

9. Appareil selon la revendication 8,
**caractérisé en ce que** le cadre périphérique est conformé en auge en forme de cuvette, dans laquelle est aménagée la plaque de support (7, 8) et **en ce que** l'auge en forme de cuvette (13) de la section de support (10) avec la plaque de support (7, 8) qui y est aménagée est remplie d'une masse de scellage (14).

10. Appareil selon l'une quelconque des revendications précédentes, **caractérisé en ce qu'**il est prévu un joint d'étanchéité (20) entre des sections de face frontale contiguës l'une à l'autre d'éléments de plaque de fermeture (17, 18) respectifs.

11. Appareil selon l'une quelconque des revendications précédentes, **caractérisé en ce que**
la plaque de fermeture (16) est entourée d'une masse de scellage (21) sur la face externe.
